Europäisches Patentamt

**European Patent Office**

Office européen des brevets

(11) Veröffentlichungsnummer: **0 013 952**
**B1**

(12) **EUROPÄISCHE PATENTSCHRIFT**

(45) Veröffentlichungstag der Patentschrift:
25.05.83

(21) Anmeldenummer: **80100255.1**

(22) Anmeldetag: **21.01.80**

(51) Int. Cl.³: **H 01 L 41/08, H 04 R 17/00,
D 01 F 8/00, D 02 G 3/44,
D 01 D 5/24**

(54) **Faden mit Leitschichten und dessen Verwendung.**

(30) Priorität: **24.01.79 DE 2902545**

(43) Veröffentlichungstag der Anmeldung:
**06.08.80 Patentblatt 80/16**

(45) Bekanntmachung des Hinweises auf die Patenterteilung:
**25.05.83 Patentblatt 83/21**

(84) Benannte Vertragsstaaten:
**AT CH FR GB IT NL**

(56) Entgegenhaltungen:
**AT-B-336 765
DE-A-756 697
DE-A-1 710 628
FR-A-1 203 493
US-A-4 045 949**

(73) Patentinhaber: **Akzo GmbH,
Postfach 10 01 49 Kasinostrasse 19-23,
D-5600 Wuppertal-1 (DE)**

(72) Erfinder: **Bülle, Wolfgang,** Hindenburgstr. 6,
D-7808 Waldkirch **(DE)**
Erfinder: **Tilgner, Hans-Georg, Dr. Dipl.-Chem.,
Lübeckerstrasse 28, D-4330 Mülheim (DE)**

## Faden mit Leitschichten und dessen Verwendung

Die Erfindung betrifft einen Faden gemäß dem ersten Teil des Anspruchs 1.

Aus der DE-A-1 710 628 ist ein derartiger Faden bekannt. Er besteht aus mindestens zwei Komponenten, die sich im wesentlichen entlang der Fadenachse erstrecken und in einem beliebigen Querschnitt des Fadens mindestens zehn dünne Schichten bilden. Dabei kann eine der Komponenten eine Substanz zur Erhöhung der elektrischen Leitfähigkeit sein, um elektrostatische Aufladungen abzuleiten. Als Substanzen für die elektrisch leitfähigen Schichten werden organische Verbindungen vorgeschlagen, die zur Ableitung der statischen Elektrizität geeignet sind. Für andere Anwendungszwecke wie sie mit der vorliegenden Erfindung angestrebt werden, sind diese bekannten Fäden aber ungeeignet.

Auch der aus der US-PS 4 045 949 bekannte elektrisch leitende textile Faden mit 2 bis 1000 elektrisch leitfähigen, längs der Fadenachse ausgerichteten Streifen und damit verbundenen nicht leitenden Streifen aus Polymermaterial dienen der Ableitung der statischen Elektrizität von textilen Synthesefäden. Auch dieser Faden ist für die angestrebten Anwendungszwecke ungeeignet.

Es ist bekannt, daß ein Gebilde, welches aus zwei elektrisch leitenden Platten, die durch ein Dielektrikum voneinander isoliert sind, eine definierte elektrische Kapazität aufweist und somit einen Kondensator bildet. Gut bekannt sind Wickelkondensatoren aus Kunststoff-Folien mit Belägen aus Metallfolie, oder Metallbeläge, die unmittelbar auf die Kunststoff-Folien aufgedampft sind. Derartige Folien werden gewickelt und bilden anschließend den Kondensator.

Es ist auch bekannt, daß piezoelektrische Kunststoff-Folien die mit leitenden Belägen versehen sind sich hervorragend für elektroakustische Wandler eignen, und sich inzwischen für Mikrofone, Tonabnehmer, Hochtonlautsprecher bewährt haben. Beschrieben sind derartige elektroakustische Wandler beispielsweise in der BE-A-858 882, den DE-A-2 623 930 und 2 742 133, sowie der US-A-4 064 375.

Die Folien müssen sowohl für die Anwendung als Kondensatoren als auch zu elektroakustischen Wandlern sehr mühsam und sorgfältig verarbeitet und gewickelt werden. Für Miniaturbauteile lassen sich die Folien nur schwierig rationell vorbereiten und verarbeiten. Außerdem müssen trotz aller Sorgfalt in der Produktion, große Abweichungen von den Normdaten in Kauf genommen werden.

Aufgabe der vorliegenden Erfindung war es, diese genannten Nachteile zu überwinden und Materialien zur Verfügung zu stellen, die die Anwendungsmöglichkeiten noch erweitern.

Ausgehend von einem Faden, wie er aus der DE-A-1 210 628 bekannt war, dessen Querschnitt senkrecht zur Fadenlaufrichtung mindestens drei Schichten aufweist, von denen mindestens zwei Schichten elektrisch leitend sind und von denen wenigstens eine Schicht eine zwischen den leitenden Schichten liegende, aus einem elektrisch isolierenden synthetischen Polymeren bestehende Isolierschicht ist, wird die Aufgabe erfindungsgemäß gelöst durch einen solchen Faden, der dadurch gekennzeichnet ist, daß die Isolierschicht senkrecht zur Fadenlaufrichtung einen hohlförmigen Querschnitt aufweist, daß eine der elektrisch leitenden Schichten eine auf der Außenfläche der Isolierschicht angeordnete, sich über deren ganzen Umfang erstreckende äußere leitende Schicht darstellt und das wenigstens die äußere leitende Schicht eine galvanisch abgeschiedene Metallschicht ist.

Kern-Mantel-Bikomponentenfäden sind bereits in großer Vielfalt zu verschiedenen Zwekken hergestellt worden. Unter anderem sind auch bereits Kern-Mantel-Bikomponentenfäden mit einem elektrisch leitenden Kern hergestellt worden, wie sie beispielsweise in der GB-A-816 965, der US-A-3 003 223 und der DE-A-2 337 103 beschrieben werden. Der erfindungsgemäße Faden kann nach analogen Spinnverfahren oder anderen Verfahren, wie sie in großer Zahl im Stande der Technik beschrieben sind, hergestellt werden. Wesentlich ist jedoch, daß dabei oder in einer nachgestalteten Verfahrensstufe, die elektrisch leitfähigen Schichten erzeugt werden. Beispielsweise können zur Haftungsvermittlung für galvanische Überzüge beim Spinnprozeß zusätzlich dünne Zwischenschichten aus Polymer-Metallpulver-Gemischen extrudiert werden, wobei dann entsprechende, bekannte Mehrkomponentendüsen mit mehreren konzentrischen Ringschlitzen verwendet werden, denen die unterschiedlichen Schmelzströme zugeführt werden. Geeignete Vorrichtungen beschreibt die NL-A-6 712 909.

Insbesondere dann, wenn dem erfindungsgemäßen Faden piezoelektrische Eigenschaften durch eine Nachbehandlung des Polymeren vermittelt werden sollen, ist es sinnvoll, daß die Kernkomponente kompressibel ist. Eine geeignete Ausführungsform besteht darin, als Kernkomponente eine elektrisch leitende hochviskose Flüssigkeit mit darin dispergierten Metall- und/oder Ruß- und/oder Graphitteilchen einzusetzen. Geeignete hochviskose Flüssigkeiten sind beispielsweise Cis- und Trans-Polyacethylene mit relativ geringem Molekulargewicht, die gegebenenfalls einen geringen Anteil Jod oder Arsenpentachlorid enthalten.

Eine besonders bevorzugte Ausführungsform der Erfindung besteht darin, daß der Faden ein im Fadenquerschnitt aus mindestens drei Schichten aufgebauter Hohlfaden ist. Die Herstellung der im Inneren des Hohlfadens liegenden elektrisch leitenden Schicht kann so erfolgen, daß beim Extrudieren des Hohlfadens eine Mehrkomponentenhohlfadendüse verwendet wird und mit dem isolierenden Polymeren gemeinsam eine Zwischenschicht aus einem Polymer-Metallpulver-Gemisch koextrudiert wird. In den Hohlraum wird durch ein durch die Spinndüsenöffnung durchgeführtes Rohr in einem ausreichenden Abstand von der Austrittsstelle des frisch gesponnenen Fadens eine Lösung zur chemischen Abscheidung von Kupfer oder Nickel in den Hohlraum des Fadens gespritzt, durch die während der Nachbehandlung des Fadens eine vollständige Bedeckung der Innenwandfläche mit dem Metall erfolgt.

Falls es erforderlich ist, kann diese Metallschicht nach Aufteilung des Fadens in geeignete Abschnitte und Austausch der Hohlraumflüssigkeit durch ein galvanisches Bad mit einem weiteren Metallüberzug durch galvanische Abscheidung verstärkt werden.

Diese Galvanische Abscheidung kann gleichzeitig mit der Abscheidung der elektrisch leitenden äußeren Schicht erfolgen. Zur Haftverbesserung ist es vorteilhaft, wenn auch außen eine dünne Außenschicht eines Polymer-Metallpulver-Gemisches koextrudiert wird.

Der Faden gemäß der Erfindung wird nach den für die Herstellung von synthetischen Fäden bekannten Technologien hergestellt. Die Fadendurchmesser entsprechen auch den von dort bekannten Abmessungen von ca. 10 µm bis zu etwa 3 mm. Vorzugsweise liegen die Fadendurchmesser jedoch zwischen 50 und 1000 µm. Typische Fadendurchmesser sind 180 µm, 250 µm und 450 µm. Bei Hohlfäden beträgt die Wandstärke im allgemeinen 1/8 bis 1/20 des Fadendurchmessers. Typisch sind hier Wandstärken von 10 bis 100 µm.

Der erfindungsgemäße Faden muß aus mindestens drei Schichten aufgebaut sein, kann aber auch zusätzliche Schichten aufweisen, wo dieses zweckmäßig und sinnvoll erscheint. In vielen Fällen wird der Faden mit Zwischenschichten zur Erhöhung der Haftung der elektrisch leitenden Schichten hergestellt. Diese Zwischenschichten enthalten im allgemeinen Metallpulver zur Erhöhung der Leitfähigkeit der Zwischenschicht, die aber zu gering ist, als daß die Zwischenschicht bereits als Kontaktschicht gelten könnte. In vielen Fällen ist es sinnvoll, den Faden außen mit einer isolierenden Schutzschicht zu versehen, während die übrigen Schichten mit Ausnahme der Kontaktschichten im allgemeinen bei der Fadenbildung erzeugt werden, wird die Schutzschicht erst nach Fertigstellung des übrigen Fadens aufgebracht.

Die elektrisch isolierende Schicht zwischen den Kontaktschichten kann selbst aus mehreren isolierenden Schichten, beispielsweise aus unterschiedlichen Polymeren bestehen. Durch eine solche Ausbildung des Erfindungsgegenstandes können Eigenschaften der Polymeren in stärkerem Maße miteinander kombiniert, beispielsweise gute Piezoelektrizität des einen Polymeren mit mechanischen Eigenschaften des anderen Polymeren, zur Wirkung kommen.

Der erfindungsgemäße Faden läßt sich auf üblichen Textilmaschinen verarbeiten (Spulen, Zwirnen etc.). Gewebe, Gewirke und Stücke können beispielsweise zugleich dekorative Verkleidung und technisch funktionelles Teil, beispielsweise eine Schallwand bilden.

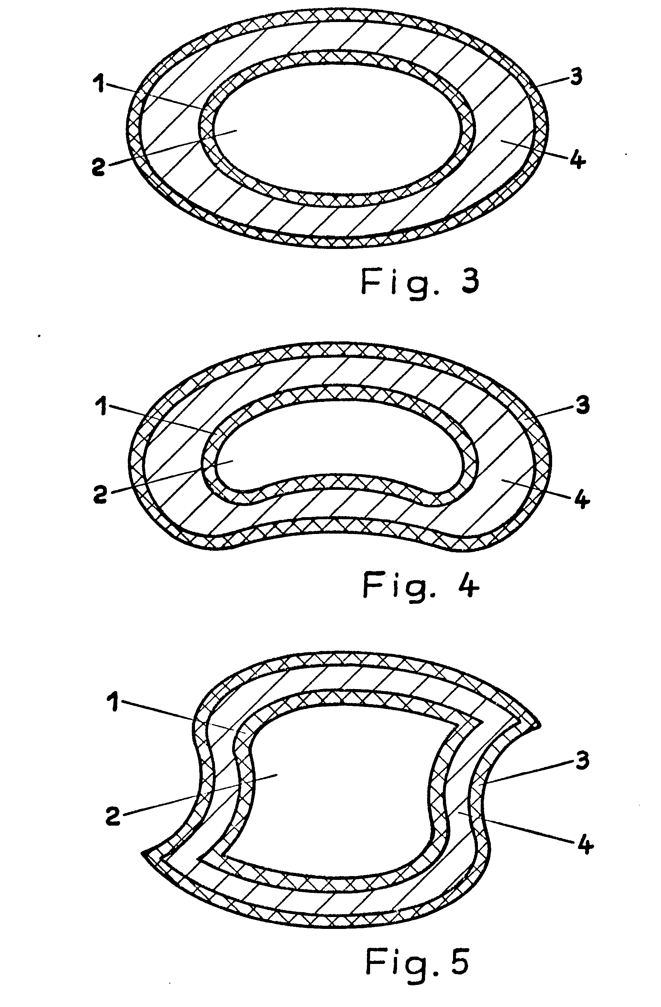

Besondere Ausführungsformen der Erfindung ergeben sich dadurch, daß der Faden vom Kreisquerschnitt abweicht. Beispiele für solche, von der Kreisform abweichende Fadenquerschnitte, von Hohlfäden sind in den Fig. 3 bis 5 dargestellt.

Als Polymere sind für den erfindungsgemäßen Faden alle Polymeren geeignet, die aus der Schmelze und/oder aus Lösungen zu Fäden verformbar sind und eine hohe Dielektrizitätskonstante aufweisen. Es können beispielsweise Polyamide, einschließlich der aromatischen Polyamide, Polyester, insbesondere Polyalkylenterephthalate, Polycarbonate, Polyvinylidenfluorid, Polyurethane, Polyphosphazene als synthetisches Polymer für die isolierende Zwischenschicht eingesetzt werden.

Vorteilhaft, insbesondere im Hinblick auf die Auslösung von piezoelektrischen Eigenschaften, soll das elektrisch isolierende synthetische Polymere mindestens teilweise kristallisierbar sein. Nicht nur im Hinblick auf die piezoelektrischen Eigenschaften soll das Polymere molekular orientierbar sein. Durch die molekulare Orientierung werden die mechanischen Eigenschaften des erfindungsgemäßen Fadens wesentlich verbessert.

Es ist bekannt, daß die überwiegende Zahl der zuvor beispielhaft aufgezählten Polymeren, insbesondere, wenn sie zumindestens teilweise kristallisierbar sind, bei Einwirkung einer Gleichspannung bei erhöhter Temperatur bleibende piezoelektrische Eigenschaften erhalten. Ein auf das Polymere ausgeübter Druck erzeugt elektrische Impulse, die durch die Leitschichten aufgenommen und weitergeleitet werden. Legt man Wechselspannungen an die Leitschichten an, dann wird das Polymere in Schwingungen versetzt.

Methoden, nach denen Polymeren piezoelektrische Eigenschaften vermittelt werden, sind bereits beschrieben worden und auch auf Polymerfolien in größerem Maßstab angewendet worden. Hier können beispielsweise die NL-A-7 113 160 und die DE-A-2 719 881 genannt werden.

Der erfindungsgemäße Faden kann mit geeigneten Abmessungen als Kondensator eingesetzt werden, wenn jeweils die innere und die äußere elektrisch leitende Schicht mit einem Anschluß versehen werden.

Die Kapazität des Kondensators ergibt sich aus den gewählten Abmessungen und läßt sich nach der Formel

$$C = 0{,}0885 \cdot \varepsilon \cdot \frac{A}{d}$$

berechnen, worin C die Kapazität des Kondensators in pF, ε die relative Dielektrizitätskonstante

des die isolierende Zwischenschicht bildenden synthetischen Polymeren, d die Dicke dieser Zwischenschicht in cm und A die Oberfläche des für den Kondensator in Betracht kommenden Fadenabschnittes in cm² ist.

Bei einem Kern-Mantel-Faden mit einem elektrisch leitenden Kern kann dieser Kern mit einer genau bestimmten spezifischen Leitfähigkeit durch Mischung von Ruß und/oder Metallpulver mit geeigneten Polymeren hergestellt werden.

Ein derartiger Kondensator weist dann an der inneren Kontaktstelle dadurch gleichzeitig einen definierten elektrischen Widerstand auf, so daß Kondensatoren entstehen, die sehr platzsparend gleich als RC-Glieder in elektronische Schaltungen eingebaut werden können.

Der erfindungsgemäße Faden läßt sich ohne Einschränkung auf Textilmaschinen verarbeiten, woraus sich zahlreiche weitere vorteilhafte Möglichkeiten ergeben.

Insbesondere für Bauteile mit kleiner Kapazität, mit besonders kleinen Abmessungen, wie sie für hohe und höchste Ansprüche erwünscht sind, läßt sich der erfindungsgemäße Faden hervorragend verwenden.

Erfindungsgemäß läßt sich der Faden gemäß der Erfindung der piezoelektrische Eigenschaften aufweist, zu elektroakustischen Wandlersystemen verwenden.

Flachmembranen haben sich hier bereits bewährt, bringen jedoch beim Einbau zahlreiche Schwierigkeiten mit sich. Vorteilhaft ist es, dazu erfindungsgemäße Hohlfäden einzusetzen, die sich zu Mikrofonen, Lautsprechern, Telefonkapseln und Kopfhörern mit gleichbleibenden und guten technischen Daten, wie beispielsweise Übertragungsbereich, Frequenzgang und Empfindlichkeit herstellen lassen. Wandlersysteme mit dem erfindungsgemäßen Faden weisen vor allem einen geringen Klirrfaktor auf und sind auch bei tieferen Hörfrequenzen einsetzbar. Für Tonabnehmersysteme sind vor allem auch Hohlfäden einsetzbar, die eine von der Kreisform abweichende Querschnittsform aufweisen, wie sie in den Fig. 3 bis 5 dargestellt sind.

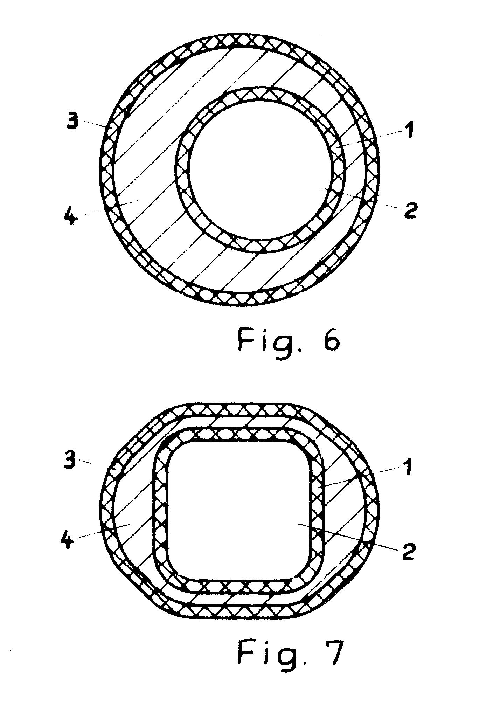

Der erfindungsgemäße Faden kann, wenn ihm durch Polarisation im Gleichspannungsfeld piezoelektrische Eigenschaften vermittelt wurden, erfindungsgemäß auch zu piezoelektrischen Sensoren auf mechanische Beanspruchungen verwendet werden. Hierzu ist z. B. die in Fig. 6 und 7 dargestellte Querschnittsform geeignet. Entsprechende erfindungsgemäße Fäden können beispielsweise in Gewebe oder Gewirke als Meßsonden eingewebt werden. Der erfindungsgemäße Faden kann auch in einer Sportfechtwaffe als Sensor eingesetzt werden, um die elektrischen Impulse für die Trefferanzeige zu gewinnen. Ferner lassen sich mit dem erfindungsgemäßen Faden Sensorschalter herstellen.

Der erfindungsgemäße Faden ist als Hohlfaden mit genau kreisförmigen Querschnitten hervorragend als flexibler Hohlleiter für die Übertragung höchster Frequenzen geeignet, da er durch die Spinntechnik in so geringen Querabmessungen herstellbar ist, daß der Radius des Hohlraumquerschnittes klein gegenüber der Wellenlänge selbst bei höchsten Frequenzen bleibt. Der erfindungsgemäße Hohlfaden läßt sich ohne Schwierigkeit mit einem Radius des Hohlraumquerschnittes von 30 μm herstellen.

Aus diesen geringen Abmessungen des Hohlraumquerschnittes ergibt sich auch die Verwendung des erfindungsgemäßen Fadens für Topfkreise im Bereich höchster Frequenzen (bis in den hohen Gigaherzbereich hinein).

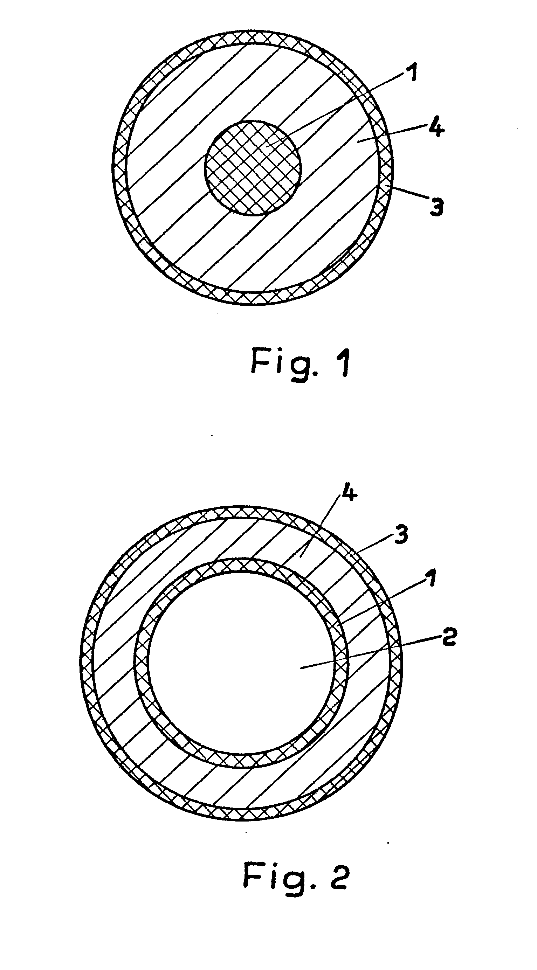

In den Fig. 1 bis 7 sind Fadenquerschnitte dargestellt, die beispielsweise der erfindungsgemäße Faden aufweisen kann.

Mit 1 wird jeweils die innere elektrisch leitende Schicht bezeichnet, sofern Hohlfäden dargestellt sind, ist der Hohlraum mit 2 bezeichnet, während 3 die äußere elektrisch leitende Schicht ist. Die dazwischen liegende Schicht aus einem elektrisch isolierenden synthetischen Polymeren ist mit 4 bezeichnet worden.

Im einzelnen zeigt die Fig. 1 einen Mehrkomponentenfaden vom Kern-Mantel-Typ mit einer elektrisch leitenden Kernkomponente und einer sich über den ganzen Umfang erstreckenden elektrisch leitenden äußeren Schicht.

Fig. 2 zeigt einen Hohlfaden, wobei die Größenverhältnisse bewußt wegen der größeren Klarheit in den Abmessungen nicht maßstabsgerecht gezeichnet sind, der genau kreisförmige Querschnitte aufweist.

In den Fig. 3 bis 5 sind Hohlfadenquerschnitte — ebenfalls nicht maßstabsgerecht — mit von der Kreisform abweichenden Querschnittsformen dargestellt.

In Fig. 6 ist ein Hohlfaden mit kreisförmigem Querschnitt dargestellt, wobei die äußere Begrenzung und die Innenbegrenzung zueinander exzentrisch sind. Daraus ergeben sich regelmäßig unterschiedliche Wandstärken, die bei elektroakustischen Wandlern zu besonderen Abstrahlungs- und Frequenzgangeinflüssen führen.

Fig. 7 zeigt eine Hohlfadenquerschnittsform, die von der Kreisform abweicht und bei der die Wandstärke über den Umfang nicht konstant ist.

**Patentansprüche**

1. Faden, dessen Querschnitt senkrecht zur Fadenlaufrichtung mindestens drei Schichten aufweist, von denen mindestens zwei Schichten (1, 3) elektrisch leitend sind und von denen wenigstens eine Schicht eine zwischen den leitenden Schichten liegende, aus einem elektrisch isolierenden synthetischen Polymeren bestehende Isolierschicht (4) ist, dadurch gekennzeichnet, daß die Isolierschicht (4) senkrecht zur Fadenlaufrichtung einen hohlförmigen Querschnitt aufweist, daß eine der elektrisch leitenden Schichten (3) eine auf der Außenfläche der Isolierschicht (4) angeordnete, sich über deren ganzen Umfang erstreckende äußere leitende Schicht darstellt und daß wenigstens die äußere leitende Schicht (3) eine galvanisch abgeschiedene Metallschicht ist.

2. Faden nach Anspruch 1, dadurch gekennzeichnet, daß die elektrisch leitenden Schichten mit elektrischen Anschlüssen versehen sind.

3. Faden nach den Ansprüchen 1 bis 2, dadurch gekennzeichnet, daß der Faden ein Mehrkomponentenfaden vom Kern-Mantel-Typ mit einer elektrisch leitenden Kernkomponente und einer elektrisch leitenden Oberfläche ist.

4. Faden nach den Ansprüchen 1 bis 3, dadurch gekennzeichnet, daß die Kernkomponente kompressibel ist.

5. Faden nach den Ansprüchen 1 bis 4, dadurch gekennzeichnet, daß die Kernkomponente eine elektrisch leitende, hochviskose Flüssigkeit mit darin dispergierten Metall- und/oder Ruß- und/oder Graphitteilchen ist.

6. Faden nach den Ansprüchen 1 bis 2, dadurch gekennzeichnet, daß der Faden ein im Fadenquerschnitt aus mindestens drei Schichten aufgebauter Hohlfaden ist.

7. Faden nach den Ansprüchen 1 bis 6, dadurch gekennzeichnet, daß das elektrisch isolierende synthetische Polymere mindestens teilweise kristallisierbar ist.

8. Faden nach den Ansprüchen 1 bis 7, dadurch gekennzeichnet, daß das elektrisch isolierende synthetische Polymere molekular orientierbar ist.

9. Faden nach den Ansprüchen 1 bis 8, dadurch gekennzeichnet, daß der Faden piezoelektrische Eigenschaften aufweist.

10. Verwendung des Fadens nach den Ansprüchen 1 bis 9, zu Kondensatoren für elektrische Bauteile.

11. Verwendung des Fadens nach den Ansprüchen 1 bis 9, zu elektroakustischen Wandlersystemen.

12. Verwendung des Fadens nach den Ansprüchen 1 bis 9, zu piezoelektrischen Sensoren auf mechanische Beanspruchungen.

13. Verwendung des Fadens nach den Ansprüchen 6 bis 8, zu flexiblen Hohlleitern.

14. Verwendung des Fadens nach den Ansprüchen 6 bis 8, zu Topfkreisen für höchste Frequenzen.

## Claims

1. A filament of which the cross-section — perpendicularly of the direction of travel of the filament — comprises at least three layers of which at least two layers (1, 3) are electrically conductive and of which at least one layer is an insulating layer (4) consisting of an electrically insulating synthetic polymer and being situated between the conductive layers, characterized in that the insulating layer (4) has a hollow cross-section perpendicularly of the direction of travel of the filament, in that one of the electrically conductive layers (3) is an outer conductive layer arranged on the outer surface of the insulating layer (4) and extending over the entire circumference thereof and in that at least the outer conductive layer (3) is an electrodeposited metal layer.

2. A filament as claimed in claim 1, characterized in that the electrically conductive layers are provided with electrical terminals.

3. A filament as claimed in claims 1 and 2, characterized in that the filament is a multicomponent filament of the core-jacket type comprising an electrically conductive core component and an electrically conductive surface.

4. A filament as claimed in claims 1 to 3, characterized in that the core component is compressible.

5. A filament as claimed in claims 1 to 4, characterized in that the core component is an electrically conductive highly viscous liquid with metal and/or carbon black and/or graphite particles dispersed therein.

6. A filament as claimed in claims 1 and 2, characterized in that the filament is a hollow filament consisting — in its cross section — of at least three layers.

7. A filament as claimed in Claims 1 to 6, characterized in that the electrically insulating synthetic polymer is at least partly crystallisable.

8. A filament as claimed in claims 1 to 7, characterized in that the electrically insulating synthetic polymer is molecularly orientable.

9. A filament as claimed in claims 1 to 8, characterized in that the filament has piezoelectric properties.

10. The use of the filament claimed in claims 1 to 9 for capacitors for electrical components.

11. The use of the filament claimed in claims 1 to 9 for electroacoustic transducer systems.

12. The use of the filament claimed in claims 1 to 9 for piezoelectric sensors to mechanical stress.

13. The use of the filament claimed in claims 6 to 8 for flexible hollow conductors.

14. The use of the filament claimed in claims 6 to 8 for cavity resonators for very high frequencies.

## Revendications

1. Fil dont la section perpendiculaire au sens du tracé du fil présente au moins trois couches, dont deux couches (1, 3) au moins sont conductrices de l'électricité et dont une couche au moins est une couche isolante (4), située entre les couches conductrices et constituée par un polymère synthétique qui est un isolant électrique, caractérisé en ce que la couche isolante (4) présente, perpendiculairement au sens du tracé du fil, une section creuse, en ce que l'une (3) des couches conductrices de l'électricité constitue une couche conductrice extérieure, disposée sur la surface extérieure de la couche isolante (4) et qui s'étend sur tout le pourtour de celle-ci, et en ce qu'au moins la couche conductrice extérieure (3) est une couche métallique déposée par électrolyse.

2. Fil selon la revendication 1, caractérisé en ce que les couches conductrices de l'électricité sont munies de branchements électriques.

3. Fil selon l'une quelconque des revendications 1 et 2, caractérisé en ce que le fil est un fil à plusieurs composants du type noyau ou âme-enveloppe, comportant un composant central ou du noyau qui est conducteur de l'électricité et une surface conductrice de l'électricité.

4. Fil selon l'une quelconque des revendications 1 à 3, caractérisé en ce que le composant central ou du noyau est compressible.

5. Fil selon l'une quelconque des revendications 1 à 4, caractérisé en ce que le composant central ou du noyau est un liquide conducteur de l'électricité, à haute viscosité, et contenant des particules de métal et/ou de noir de carbone et/ou de graphite dispersées.

6. Fil selon l'une quelconque des revendications 1 et 2, caractérisé en ce que le fil est un fil creux dont la section transversale est constituée par au moins trois couches.

7. Fil selon l'une quelconque des revendications 1 à 6, caractérisé en ce que le polymère synthétique qui est un isolant électrique est au moins partiellement cristallisable.

8. Fil selon l'une quelconque des revendications 1 à 7, caractérisé en ce que le polymère synthétique qui est un isolant électrique est orientable sur le plan moléculaire.

9. Fil selon l'une quelconque des revendications 1 à 8, caractérisé en ce que le fil présente des propriétés piézo-électriques.

10. Utilisation du fil selon l'une quelconque des revendications 1 à 9, pour la réalisation de condensateurs pour des composants électriques.

11. Utilisation du fil selon l'une quelconque des revendications 1 à 9, pour la réalisation de transducteurs électro-acoustiques.

12. Utilisation du fil selon l'une quelconque des revendications 1 à 9, pour la réalisation de capteurs piézo-électriques exposés à des sollicitations mécaniques.

13. Utilisation du fil selon l'une quelconque des revendications 6 à 8, pour la réalisation de guides d'ondes flexibles.

14. Utilisation du fil selon l'une quelconque des revendications 6 à 8, pour la réalisation de cavités résonnantes aux plus hautes fréquences.

Fig. 1

Fig. 2

Fig. 3

Fig. 4

Fig. 5

Fig. 6

Fig. 7